# EUROPEAN PATENT APPLICATION

(11) **EP 4 417 356 A1**
(43) Date of publication of application: **21.08.2024**
(21) Application number: 21960695.1
(22) Date of filing: 15.10.2021
(51) Int. Cl.: B23K 26/066, H05K 3/00

(54) **PROCESSING DEVICE, PROCESSING METHOD, AND SUBSTRATE MANUFACTURING METHOD**

(71) Applicant: Shin-etsu Engineering Co., Ltd., Tokyo 101-0054 (JP)
(72) Inventor: OHTANI, Yoshikazu, Annaka-shi, Gunma 379-0127 (JP); YAMAOKA, Hiroshi, Yokohamashi, Kanagawa 234-0053 (JP); KURATA, Masami, Yokohamashi, Kanagawa 234-0053 (JP); USAMI,Taketo, Yokohamashi, Kanagawa 234-0053 (JP)
(74) Representative: Meissner Bolte Partnerschaft mbB
(86) International application number: PCT/JP2021/038319
(87) International publication number: WO 2023/062842

(57) **Abstract**

The present invention is a processing apparatus that forms protrusions and recesses on a substrate surface by ablation processing using a laser beam, the apparatus including: a first optical function unit including a shaping optical system that shapes an irradiation shape of a laser beam from a laser light source into a rectangular shape; a second optical function unit including a mask containing an effective area having a pattern; and a substrate stage that holds the substrate, in which the mask includes a mask irradiation area to be irradiated with the laser beam that has passed through the first optical function unit, the mask irradiation area being a part of the effective area of the mask, the substrate includes a substrate irradiation area onto which the pattern is to be projected by the laser beam that has passed through the mask, and the substrate irradiation area is smaller than the area to be processed of the substrate, and the processing apparatus is configured to perform a surface protrusions-and-recesses forming process on the area to be processed of the substrate by performing, during processing operation on the substrate, sweep irradiation of the mask and the substrate stage while superimposing a portion of one substrate irradiation area on a portion of another substrate irradiation area. As a result, a processing apparatus that can accurately perform a minute protrusions-and-recesses forming process across the area to be processed of the substrate is provided.

## Description

### TECHNICAL FIELD

The present invention relates to a processing apparatus, a processing method, and a manufacturing method of a substrate.

### BACKGROUND ART

Semiconductor package substrates are shifting from the trend of "More Than More" to the trend of System on a Chip (SoC) of integrating the system into one chip, and are being actively developed along this trend.

Furthermore, the configuration of the semiconductor package substrate is becoming more complex and denser, and an apparatus using an excimer laser has been applied to the manufacture of a base substrate of the semiconductor package substrate.

As the semiconductor package substrate becomes denser, the wiring of the semiconductor package substrate is also required to be highly precise, and the wiring is also becoming more multilayered. Such thinning and multi-layering of the wiring leads to narrower and more complex line-and-space (L&S). As the wiring width becomes narrower, wiring resistance tends to increase.

In order to provide through-holes (VIAs) for establishing connection between wirings of multiple layers and to solve the problem of increased wiring resistance, in the fabrication of the semiconductor package substrate, trenches (grooves) are provided in the substrate and wirings are formed along the trenches. By forming such wiring, the cross-sectional area of the wiring can be increased, and therefore increase in wiring resistance can be suppressed.

An example of a production method of such semiconductor package substrate will be described below.

First, a build-up film is layered on both faces of an inner layer substrate (core layer) using a glass epoxy resin material with use of a dedicated vacuum laminator. On the surface of the build-up film thus obtained, processing to provide the through-hole and/or trench described above is performed, and a metal layer is formed on the surface of the through-hole and/or trench to form electrodes.

Meanwhile, in order to meet the demand for even higher density, the hole diameter itself of the required through-hole is becoming smaller. It is also required to form a through-hole having a cylindrical shape with a small difference between the top diameter and the bottom diameter (cylindrical VIA). The trench is also required to be a cylindrical trench.

In order to form the cylindrical hole or the cylindrical trenches with high precision by performing processing as straight as possible on the substrate, use of a laser beam with high resolution and high energy density is effective. For such processing, it is more preferable to use an excimer laser rather than a solid-state laser apparatus. Although the excimer laser has a shallow depth of focus, use of the excimer laser enables processing with high resolution and high energy density to form a cylindrical VIA or a cylindrical trench at a correct position without blur.

Patent Document 1 describes an invention related to a method and an apparatus of laser drilling. For example, claim 1 of Patent Document 1 describes that a linear or rectangular beam is irradiated via a contact mask to a processing area of a substrate to be processed by a contact mask method, and the linear or rectangular beam scans the contact mask.

Furthermore, paragraph 0037 of Patent Document 1 also describes that a laser oscillator is oscillated and a scanning mechanism moves the linear beam in the L-axis direction to irradiate the entire pattern area of the contact mask. However, with such method, it is impossible to perform processing requiring deep protrusions and recesses to a large-area substrate.

Furthermore, paragraphs 0049 and 0050 of Patent Document 1 describe that, by moving the rectangular beam using a 2-axis scanning mechanism to irradiate respective quartered areas of the contact mask with the rectangular beam in sequence to perform drilling in the area to be processed directly below the respective areas. With such method, it is possible to perform processing to the uniform depth in the inside of each area to be processed. However, in a boundary surface between the areas to be processed, the processing is not preformed, or the processing is performed in the boundary surface excessively twice the processing depth of the inside of each area to be processed, which causes problems in processing quality.

Patent Document 2 describes an invention related to a processing apparatus and a processing method for ablation processing. The processing apparatus for ablation processing in claim 1 of Patent Document 2 is provided with a scanning mechanism that moves the line beam formation unit containing the line beam forming optical system relative to the apparatus body to cause the linear light to scan.

Regarding this scanning mechanism, paragraph 0022 of Patent Document 2 describes, "The scanning mechanism 60 is capable of moving the line beam formation unit 20 back and forth along the scanning direction (X direction). As the line beam formation unit 20 moves, linear light perpendicular to the scanning direction (X direction) relatively moves relative to the mask M and the projection optical system 30, and the mask M and the substrate W fixed to the mask stage 40 and the processing stage 50, respectively, are scanned."

Furthermore, paragraph 0026 of Patent Document 2 describes, "The processing stage 50 can fix the substrate W by vacuum suction or the like and can position the substrate W with respect to the mask M by movement in the X-Y direction and rotation. Step movement is also possible along the scanning direction (in this case, the X direction) so that ablation processing can be performed across the entire substrate W. "

In addition, paragraph 0033 of Patent Document 2 describes "Linear light is caused to scan by moving the line beam formation unit 20 with respect to the apparatus body 15."

With the invention of Patent Document 2 as described above, it is impossible to perform processing requiring deep protrusions and recesses to a large-area substrate. Moreover, it is difficult to irradiate the entire area of the large mask because the laser beam is moved during scanning. Therefore, handling is difficult when the face to be irradiated of the substrate is larger. Moreover, optical devices subsequent to the mask are required to have a large size, and therefore easily deflect and are not suited to processing with high accuracy. In a case where a reduced optical lens is inserted, application of an extremely large aperture lens is required, which not only increases deflection but also makes components very expensive and makes it difficult to manage the heat from the laser beam, resulting in a problem of poor processing accuracy during long-time operation.

### CITATION LIST

### PATENT LITERATURE

Patent Document 1: JP 2001-79678 A
Patent Document 2: JP 2021-49560 A

### SUMMARY OF INVENTION

### TECHNICAL PROBLEM

Examples of a protrusions-and-recesses forming process of a semiconductor substrate includes performing protrusions-and-recesses forming process at a substrate surface by irradiating the substrate with a laser beam that has passed through an opening pattern of a mask, that is, a protrusions-and-recesses forming process by ablation processing. The ablation processing enables not only processing of through-holes, but also blind-hole processing of forming trenches with a high aspect ratio without allowing penetration therethrough.

Originally, it is ideal to irradiate the area covering the entire effective area of the mask with the laser beam whose energy is uniformed, but in recent years, the area to be processed of the semiconductor substrate surface is becoming larger, and accordingly the effective area of the mask is also becoming larger.

Therefore, when the area covering the entire effective area is irradiated with a uniform laser beam, the energy density of the laser beam is extremely reduced and does not reach processing threshold energy of the substrate surface, and processing becomes impossible. To perform processing of the substrate surface, irradiation with a laser beam having a certain degree of energy density is required. Moreover, to perform processing into a cylindrical shape with a high aspect ratio (cylindrical VIA, cylindrical trench), the energy density of the laser is required to be high, otherwise the wall surface is formed into a blunt shape.

Furthermore, the laser beam energy for performing ablation processing is required to be much higher energy density than that of an exposure system, for example, and consideration to heat is required.

Furthermore, even if energy density that enables ablation processing is provided, only one-time irradiation with the laser beam is not sufficient to process to the desired processing depth, and multiple-time irradiation is required. Especially in recent years, the demand for the aspect ratio of processing is also increasing, and the demand for a deep protrusions-and-recesses forming process is increasing. Therefore, it is required to perform deep ablation processing by irradiating the same position on the substrate with the laser beam multiple times.

Conventionally, the ablation processing apparatus and the ablation processing method as described in, for example, Patent Documents 1 and 2 have been proposed. However, as described above, these apparatus and method are not technologies that enable the minute protrusions-and-recesses forming process with accuracy across the entire area to be processed of the substrate.

The present invention has been made to solve the above-described problems, and an object thereof is to provide a processing apparatus capable of accurately performing a minute protrusions-and-recesses forming process across an area to be processed of a substrate, a processing method capable of accurately performing the minute protrusions-and-recesses forming process across the area to be processed of the substrate, and a manufacturing method of a substrate in which minute protrusions and recesses are accurately formed across the area to be processed of the substrate.

### SOLUTION TO PROBLEM

In order to solve the above-described problems, the present invention provides, as a processing apparatus of a first aspect, a processing apparatus that forms minute protrusions and recesses on a surface of a substrate by ablation processing using irradiation energy of a laser beam, the apparatus including:
a first optical function unit including a laser light source that performs irradiation with the laser beam in pulse and a shaping optical system that shapes an irradiation shape of the laser beam from the laser light source into a rectangular shape;
a second optical function unit including a mask containing an effective area having a pattern corresponding to an area to be processed of the substrate; and
a substrate stage that holds the substrate,
in which the mask includes a mask irradiation area to be irradiated with the laser beam that has passed through the first optical function unit, the mask irradiation area being a part of the effective area of the mask,
the substrate includes a substrate irradiation area onto which the pattern is to be projected by the laser beam that has passed through the mask,
the substrate irradiation area is smaller than the area to be processed of the substrate, and
the processing apparatus is configured to perform a surface protrusions-and-recesses forming process on the area to be processed of the substrate by performing, during processing operation on the substrate, sweep irradiation of the mask and the substrate stage while superimposing a portion of one substrate irradiation area on a portion of another substrate irradiation area.

With such a processing apparatus, it is possible to accurately perform a nearly uniform protrusions-and-recesses forming process across the area to be processed of the substrate. Therefore, with the processing apparatus of this aspect, it is possible to accurately perform the minute protrusions-and-recesses forming process across the area to be processed of the substrate.

Furthermore, such a processing apparatus does not require use of high laser energy, can be inexpensively configured without using an expensive laser light source and optical members, can suppress the deterioration of accuracy due to thermal drift of the laser beam, and can perform highly accurate processing.

In addition, with such a processing apparatus, a deep VIA forming process and/or trench forming process can be performed at high speed. Furthermore, since the substrate irradiation area for one shot can be made small, high-density irradiation is enabled.

Furthermore, the present invention provides, as a processing apparatus of a second aspect, a processing apparatus that forms minute protrusions and recesses on a surface of a substrate by ablation processing using irradiation energy of a laser beam, the apparatus including:
a first optical function unit including a laser light source that performs irradiation with the laser beam in pulse and a shaping optical system that shapes an irradiation shape of the laser beam from the laser light source into a rectangular shape;
a second optical function unit including a mask containing an effective area having a pattern corresponding to an area to be processed of the substrate; and
a substrate stage that holds the substrate,
in which the mask includes a mask irradiation area to be irradiated with the laser beam that has passed through the first optical function unit, the mask irradiation area being a part of the effective area of the mask,
the substrate includes a substrate irradiation area onto which the pattern is to be projected by the laser beam that has passed through the mask,
the substrate irradiation area is smaller than the area to be processed of the substrate,
the mask and the substrate stage are configured to operate in synchronization in a plane direction that is substantially perpendicular to a direction of irradiation with the laser beam to thereby maintain a relatively corresponding positional relationship therebetween, and
the processing apparatus is configured to, during processing operation on the substrate, cause the mask and the substrate stage to operate in synchronization and subject the mask and the substrate stage to sweep irradiation with an irradiation position of the laser beam being fixed to perform a surface protrusions-and-recesses forming process on the area to be processed of the substrate.

With such a processing apparatus, it is possible to accurately perform a nearly uniform protrusions-and-recesses forming process across the area to be processed of the substrate. Therefore, with the processing apparatus of this aspect, it is possible to accurately perform the minute protrusions-and-recesses forming process across the area to be processed of the substrate.

Furthermore, such a processing apparatus does not require use of high laser energy, can be inexpensively configured without using an expensive laser light source and optical members, can suppress the deterioration of accuracy due to thermal drift of the laser beam, and can perform highly accurate processing. Furthermore, since small components are available for optical components, inexpensive and highly accurate optical components can be used.

Moreover, with such processing apparatus, it is possible to perform processing with higher accuracy than in the case of scanning the laser beam. Furthermore, with such a processing apparatus, a large-area mask can also be used, and therefore processing can also be performed at higher energy density.

It is preferable that, in the processing apparatus of the first aspect, the mask and the substrate stage are configured to operate in synchronization in a plane direction that is substantially perpendicular to a direction of irradiation with the laser beam to thereby maintain a relatively corresponding positional relationship therebetween, and
the processing apparatus is configured to perform a surface protrusions-and-recesses forming process on the area to be processed of the substrate by, during processing operation on the substrate, causing the mask and the substrate stage to operate in synchronization with an irradiation position of the laser beam being fixed and subject the mask and the substrate stage to sweep irradiation while superimposing a portion of one substrate irradiation area on a portion of another substrate irradiation area.

With such a processing apparatus, it is possible to perform processing with higher accuracy than in the case of scanning the laser beam. Furthermore, with such a processing apparatus, a large-area mask can also be used, and therefore processing can also be performed at higher energy density.

It is preferable that the laser beam is an excimer laser.

Use of the excimer laser enables a more precise protrusions-and-recesses forming process. Furthermore, since the material to be processed can efficiently absorb the energy of the excimer laser, satisfactory ablation processing can be performed.

It is preferable that the processing apparatus further includes a mask stage that holds the mask and makes the mask move with sweeping.

With the processing apparatus further including such a mask stage, it is possible to efficiently perform sweep operation of the mask.

It is preferable that the processing apparatus further includes, between the second optical function unit and the substrate stage, a third optical function unit including a reduced projection optical system.

By further including such a third optical function unit, the mask can be magnified compared with the actual processing pattern, and the energy of the laser beam irradiated to the mask can be made smaller than the processing energy irradiated to the substrate. As a result, thermal drift due to the energy of the laser beam can be suppressed, and therefore thermal expansion of the mask can be suppressed, which enables highly accurate processing even after long-time processing operation. Furthermore, the mask can exhibit a larger pattern than the actual processing pattern and therefore is less affected by small dust.

It is preferable that the third optical function unit further includes a cooling means for cooling the reduced projection optical system.

With such a processing apparatus, it is possible to further suppress the thermal drift due to the energy of the laser beam, which enables highly accurate processing even after long-time processing operation.

It is preferable that the shaping optical system is an optical system that includes a plurality of cylindrical lenses and shapes the laser beam from the laser light source into a laser beam having the rectangular irradiation shape and uniform irradiation energy density.

The processing apparatus including such an optical system can shape a high-quality laser beam having a rectangular beam profile with extremely uniform energy density.

It is preferable that the shaping optical system is an optical system that includes a plurality of cylindrical lenses and shapes the laser beam from the laser light source into a laser beam that has the rectangular and top-hat type irradiation shape.

The processing apparatus including such an optical system can irradiate the area to be processed of the substrate with a top-hat type laser beam having a rectangular shape with extremely uniform energy density.

The second optical function unit may further shape the irradiation shape of the laser beam through the mask, the laser beam having passed through the first optical function unit.

The second optical function unit can further shape the irradiation shape of the laser beam shaped into a rectangular shape according to, for example, a pattern corresponding to the area to be processed of the substrate.

It is preferable that the processing apparatus is configured to make the mask and the substrate stage move with sweeping without rest in the sweep irradiation in at least one direction while irradiating the mask and the substrate stage with the laser beam in pulse.

By performing such a sweep, time of the sweep can be significantly reduced compared with the step-and-repeat operation in which traveling and rest are repeated.

Moreover, since stage operation and a rest are not repeated frequently as in step-and-repeat, the thermal load on the stage is suppressed, and highly accurate positioning can be maintained over a long time.

It is preferable that the processing apparatus further includes:
an imaging means for reading a feature portion of the substrate;
an imaging means for reading a feature portion of the mask; and
an alignment mechanism that aligns relative positions of the substrate and the mask based on positional information on the feature portion of the substrate and the feature portion of the mask.

By including these imaging means and the alignment mechanism, the processing apparatus can perform a protrusions-and-recesses forming process in which the mask pattern is projected onto the correct position of the substrate surface.

In this case, it is preferable that the processing apparatus further includes a means for correcting a processing shape of the substrate with respect to the pattern of the mask based on information of the alignment mechanism.

Such a processing apparatus enables a more correct protrusions-and-recesses forming process on the substrate.

It is preferable that the mask is installed in a substantially perpendicular direction with respect to a horizontal plane on which the processing apparatus is installed.

With such a processing apparatus, compared with the conventional type in which the mask is installed on a horizontal plane, the effect of deflection of the mask is suppressed, a highly accurate protrusions-and-recesses forming process can be performed, and adhesion of dust on the mask surface less likely occurs, which reduces defects caused by dust. Furthermore, since it is possible to align a large part of the long optical path with a horizontal plane, the height of the apparatus can be reduced.

Furthermore, the present invention provides, as a processing method of a first aspect, a processing method for forming minute protrusions and recesses on a surface of a substrate by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate, and,
during processing operation on the substrate, the mask and the substrate stage are subjected to sweep irradiation while superimposing a portion of one substrate irradiation area on a portion of another substrate irradiation area so as to perform a surface protrusions-and-recesses forming process on the area to be processed of the substrate.

With such a processing method, it is possible to accurately perform a nearly uniform protrusions-and-recesses forming process across the area to be processed of the substrate. Therefore, with the processing method of this aspect, it is possible to accurately perform the minute protrusions-and-recesses forming process across the area to be processed of the substrate.

Furthermore, such processing method does not require use of high laser energy, can be inexpensively performed without using an expensive laser light source and optical members, can suppress the deterioration of accuracy due to thermal drift of the laser beam, and enables highly accurate processing.

Moreover, with such processing method, a deep VIA forming process and/or trench forming process can be performed at high speed. Furthermore, since the substrate irradiation area for one shot can be made small, high-density irradiation is enabled.

Furthermore, the present invention provides, as a processing method of a second aspect, a processing method for forming minute protrusions and recesses on a surface of a substrate by ablation processing using irradiation energy of a laser beam, the method including:
allowing the laser beam shaped into a rectangular shape to pass through a mask to thereby irradiate the substrate with the laser beam so as to make a substrate irradiation area smaller than an area to be processed of the substrate; and
performing, during processing operation on the substrate, a surface protrusions-and-recesses forming process on the area to be processed of the substrate while superimposing a portion of one substrate irradiation area on a portion of another substrate irradiation area.

With such a processing method, it is possible to accurately perform a nearly uniform protrusions-and-recesses forming process across the area to be processed of the substrate. Therefore, with the processing apparatus of this aspect, it is possible to accurately perform the minute protrusions-and-recesses forming process across the area to be processed of the substrate.

Furthermore, the present invention provides, as a processing method of a third aspect, a processing method for forming minute protrusions and recesses on a surface of a substrate by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate,
the mask and the substrate stage are caused to operate in synchronization in a plane direction that is substantially perpendicular to a direction of irradiation with the laser beam to thereby maintain a relatively corresponding positional relationship therebetween, and,
during processing operation on the substrate, with an irradiation position of the laser beam being fixed, the mask and the substrate stage are caused to operate in synchronization and subjected to sweep irradiation to perform a surface protrusions-and-recesses forming process on the area to be processed of the substrate.

With such a processing method, it is possible to accurately perform a nearly uniform protrusions-and-recesses forming process across the area to be processed of the substrate. Therefore, with the processing method of this aspect, it is possible to accurately perform the minute protrusions-and-recesses forming process across the area to be processed of the substrate.

Furthermore, such a processing method does not require use of high laser energy, can be inexpensively configured without using an expensive laser light source and optical members, can suppress the deterioration of accuracy due to thermal drift of the laser beam, and enables highly accurate processing. Furthermore, since small components are available for optical components, inexpensive and highly accurate optical components can be used.

Moreover, with such a processing method, it is possible to perform processing with higher accuracy than in the case of scanning the laser beam. Furthermore, with such a processing method, a large-area mask can also be used, and therefore processing can also be performed at higher energy density.

In the processing method of the first aspect, it is preferable that the mask and the substrate stage are caused to operate in synchronization in a plane direction that is substantially perpendicular to a direction of irradiation with the laser beam to thereby maintain a relatively corresponding positional relationship therebetween, and,
during processing operation on the substrate, with an irradiation position of the laser beam being fixed, the mask and the substrate stage are caused to operate in synchronization and subjected to sweep irradiation while superimposing a portion of one substrate irradiation area on a portion of another substrate irradiation area so as to perform a surface protrusions-and-recesses forming process on the area to be processed of the substrate.

With such a processing method, it is possible to perform processing with higher accuracy than in the case of scanning the laser beam. Furthermore, with such processing method, a large-area mask can also be used, and therefore processing can also be performed at higher energy density.

It is preferable that an excimer laser is used as the laser beam.

Use of the excimer laser enables a more precise protrusions-and-recesses forming process. Furthermore, the material to be processed can efficiently absorb the energy of the excimer laser, and therefore satisfactory ablation processing can be performed.

In the processing method of the first aspect or the third aspect, it is preferable that a mask stage that holds the mask and makes the mask move with sweeping is further used.

In this manner, sweep operation of the mask can be efficiently performed.

In the processing method of the first aspect or the third aspect, it is preferable to use the processing apparatus further including, between the second optical function unit and the substrate stage, a third optical function unit with a reduced projection optical system.

By using the processing apparatus further including such a third optical function unit, the mask can be magnified compared with the actual processing pattern, and the energy of the laser beam irradiated to the mask can be made smaller than the processing energy irradiated to the substrate. As a result, thermal drift due to the energy of the laser beam can be suppressed and therefore thermal expansion of the mask can be suppressed, which enables highly accurate processing even after long-time processing operation. Furthermore, the mask can have a larger pattern than the actual processing pattern, and therefore is less affected by small dust.

In this case, it is preferable to use the third optical function unit further including a cooling means for cooling the reduced projection optical system.

Use of such third optical function unit enables highly accurate processing even after long-time processing operation.

In the processing method of the first aspect or the third aspect, it is preferable to use an optical system including a plurality of cylindrical lenses as the shaping optical system to shape the laser beam from the laser source into a uniform laser beam having the rectangular irradiation shape.

In this manner, it becomes possible to shape a high-quality laser beam having a rectangular beam profile with extremely uniform energy density.

In the processing method of the first aspect or the third aspect, in the second optical function unit, the irradiation shape of the laser beam that has passed through the first optical function unit can be further shaped through the mask.

The second optical function unit can further shape the irradiation shape of the laser beam shaped into the rectangular shape according to, for example, a pattern corresponding to the area to be processed of the substrate.

In the processing method of the first aspect or the third aspect, it is preferable that, in the sweep irradiation in at least one direction, the mask and the substrate stage are made to move with sweeping without rest while being irradiated with the laser beam in pulse.

By performing such sweep, time of the sweep can be significantly reduced compared with the step-and-repeat operation in which traveling and rest are repeated.

Moreover, since stage operation and a rest are not repeated frequently as in step-and-repeat, the thermal load on the stage is suppressed and highly accurate positioning can be maintained over a long time.

In the processing method of the first aspect or the third aspect, the sweep irradiation can be repeatedly performed multiple times for each area to be processed of the substrate.

By repeating sweep irradiation multiple times for each area to be processed in this manner to perform processing to the desired depth, high-speed processing are enabled.

It is preferable that the processing method of the first aspect or the third aspect further includes:
reading a feature portion of the substrate and a feature portion of the mask; and
aligning, by using an alignment mechanism, relative positions of the substrate and the mask based on positional information on the feature portion of the substrate and the feature portion of the mask.

In this manner, it becomes possible to perform a protrusions-and-recesses forming process in which the mask pattern is projected onto the correct position of the substrate surface.

In this case, it is preferable that the processing method further includes correcting a processing shape of the substrate with respect to the pattern of the mask based on the information of the alignment mechanism.

Such a processing method enables a more correct protrusions-and-recesses forming process on the substrate.

In the processing method of the first aspect or the third aspect, it is preferable to use the processing apparatus in which the mask is installed in a perpendicular direction with respect to a horizontal plane on which the processing apparatus is installed.

Compared with the conventional type in which the mask is installed on a horizontal plane, use of such a processing apparatus can suppress the effect of deflection of the mask to perform a highly accurate protrusions-and-recesses forming process, and is less likely to cause adhesion of dust on the mask surface, which reduces defects caused by dust. Moreover, since it is possible to align a large part of the long optical path with a horizontal plane, the height of the apparatus can be reduced.

Furthermore, the present invention provides, as a manufacturing method of a substrate of a first aspect, a manufacturing method of a substrate having a surface on which minute protrusions and recesses are formed by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate and,
during processing operation on the substrate, the mask and the substrate stage are subjected to sweep irradiation while superimposing a portion of one substrate irradiation area on a portion of another substrate irradiation area so as to perform a surface protrusions-and-recesses forming process on the area to be processed of the substrate.

With such a manufacturing method of a substrate, it is possible to accurately perform a nearly uniform protrusions-and-recesses forming process across the area to be processed of the substrate. Therefore, the manufacturing method of a substrate of this aspect allows manufacturing of the substrate in which minute protrusions and recesses are accurately formed across the area to be processed of the substrate.

Furthermore, such a manufacturing method of a substrate does not require use of high laser energy, can be inexpensively performed without using an expensive laser light source and optical members, can suppress the deterioration of accuracy due to thermal drift of the laser beam, and enables manufacturing of the highly-accurately processed substrate.

With such a manufacturing method of a substrate, a deep VIA forming process and/or trench forming process can be performed at high speed. Furthermore, since the substrate irradiation area for one shot can be made small, high-density irradiation is enabled.

Furthermore, the present invention provides, as a manufacturing method of a second aspect, a manufacturing method of a substrate having a surface on which minute protrusions and recesses are formed by ablation processing using irradiation energy of a laser beam, the method including:
a processing method for forming minute protrusions and recesses on a surface of a substrate by ablation processing using irradiation energy of a laser beam,
in which the laser beam shaped into a rectangular shape is allowed to pass through a mask to thereby irradiate the substrate with the laser beam so as to make a substrate irradiation area smaller than an area to be processed of the substrate and,
during processing operation on the substrate, a surface protrusions-and-recesses forming process on the area to be processed of the substrate is performed while superimposing a portion of one substrate irradiation area on a portion of another substrate irradiation area.

With such a manufacturing method of a substrate, it is possible to accurately perform a nearly uniform protrusions-and-recesses forming process across the area to be processed of the substrate. Therefore, the manufacturing method of a substrate of this aspect allows manufacturing of the substrate in which minute protrusions and recesses are accurately formed across the area to be processed of the substrate.

Furthermore, the present invention provides, as a manufacturing method of a third aspect, a manufacturing method of a substrate having a surface on which minute protrusions and recesses are formed by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate,
the mask and the substrate stage are caused to operate in synchronization in a plane direction that is substantially perpendicular to a direction of irradiation with the laser beam to thereby maintain a relatively corresponding positional relationship therebetween, and
during processing operation on the substrate, the mask and the substrate stage are caused to operate in synchronization with an irradiation position of the laser beam being fixed and subjected to sweep irradiation to perform a surface protrusions-and-recesses forming process on the area to be processed of the substrate.

With such a manufacturing method of a substrate, it is possible to accurately perform a nearly uniform protrusions-and-recesses forming process across the area to be processed of the substrate. Therefore, the manufacturing method of a substrate of this aspect allows manufacturing of the substrate in which minute protrusions and recesses are accurately formed across the area to be processed of the substrate.

Furthermore, such a manufacturing method of a substrate does not require use of high laser energy, can be inexpensively performed without using an expensive laser light source and optical members, can suppress the deterioration of accuracy due to thermal drift of the laser beam, and enables manufacturing of the highly-accurately processed substrate. Furthermore, since small components are available for optical components, inexpensive and highly accurate optical components can be used.

Moreover, with such a manufacturing method of a substrate, it is possible to perform processing with higher accuracy than in the case of scanning the laser beam. Furthermore, with such a processing method, a large-area mask can also be used, and therefore processing can also be performed at higher energy density.

For example, the substrate may be a substrate for a semiconductor package.

The manufacturing method of a substrate of the present invention can be applied particularly advantageously to manufacturing of a semiconductor package.

### ADVANTAGEOUS EFFECTS OF INVENTION

As described hereinabove, according to the processing apparatus according to the present invention, it is possible to accurately perform the minute protrusions-and-recesses forming process across the area to be processed of the substrate.

Furthermore, according to the processing method of the present invention, it is possible to accurately perform the minute protrusions-and-recesses forming process across the area to be processed of the substrate.

In addition, according to the manufacturing method of a substrate of the present invention, it is possible to manufacture the substrate in which minute protrusions and recesses are accurately formed across the area to be processed of the substrate.

### BRIEF DESCRIPTION OF DRAWINGS

FIG. 1 is a schematic illustration showing an example of a processing apparatus of the present invention;
FIG. 2 is an illustration showing an example of a relationship between an area to be processed of a substrate and a substrate irradiation area in the present invention;
FIG. 3 is an illustration describing an example of superimposed irradiation in a uniaxial direction;
FIG. 4 is an illustration describing an example of the superimposed irradiation from the first row to the third row; and
FIG. 5 is a conceptual illustration of shaping an irradiation shape of a laser beam in an example of the shaping optical system.

### DESCRIPTION OF EMBODIMENTS

As described above, there has been a demand for development of a processing apparatus capable of accurately performing a minute protrusions-and-recesses forming process across an area to be processed of a substrate.

As a result of intensive studies against the above-described problems, the present inventors have found that, in processing for forming minute protrusions and recesses on a surface of a substrate by ablation processing using irradiation energy of a laser beam, it is possible to perform the minute protrusions-and-recesses forming process across an area to be processed of the substrate by making the substrate irradiation area to be irradiated with the laser beam of one shot smaller than the area to be processed of the substrate, performing, during processing operation on the substrate, sweep irradiation of a mask and a substrate stage while superimposing a portion of one substrate irradiation area on a portion of another substrate irradiation area to perform a surface protrusions-and-recesses forming process on the area to be processed of the substrate, and/or causing the mask and the substrate stage to operate in synchronization with an irradiation position of the laser beam being fixed and subjecting the mask and the substrate stage to sweep irradiation to perform the surface protrusions-and-recesses forming process on the area to be processed of the substrate. Thereby, the present inventors completed the present invention.

That is, the processing apparatus of the first aspect of the present invention is a processing apparatus that forms minute protrusions and recesses on a surface of a substrate by ablation processing using irradiation energy of a laser beam, the apparatus including:
a first optical function unit including a laser light source that performs irradiation with the laser beam in pulse and a shaping optical system that shapes an irradiation shape of the laser beam from the laser light source into a rectangular shape;
a second optical function unit including a mask containing an effective area having a pattern corresponding to an area to be processed of the substrate; and
a substrate stage that holds the substrate,
in which the mask includes a mask irradiation area to be irradiated with the laser beam that has passed through the first optical function unit, the mask irradiation area being a part of the effective area of the mask,
the substrate includes a substrate irradiation area onto which the pattern is to be projected by the laser beam that has passed through the mask,
the substrate irradiation area is smaller than the area to be processed of the substrate, and
the processing apparatus is configured to perform a surface protrusions-and-recesses forming process of the area to be processed of the substrate by performing, during processing operation on the substrate, sweep irradiation of the mask and the substrate stage while superimposing a portion of one substrate irradiation area on a portion of another substrate irradiation area.

Furthermore, the processing apparatus of the second aspect of the present invention is a processing apparatus that forms minute protrusions and recesses on a surface of a substrate by ablation processing using irradiation energy of a laser beam, the apparatus including:
a first optical function unit including a laser light source that performs irradiation with the laser beam in pulse and a shaping optical system that shapes an irradiation shape of the laser beam from the laser light source into a rectangular shape;
a second optical function unit including a mask containing an effective area having a pattern corresponding to an area to be processed of the substrate; and
a substrate stage that holds the substrate,
in which the mask includes a mask irradiation area to be irradiated with the laser beam that has passed through the first optical function unit, the mask irradiation area being a part of the effective area of the mask,
the substrate includes a substrate irradiation area onto which the pattern is to be projected by the laser beam that has passed through the mask,
the substrate irradiation area is smaller than the area to be processed of the substrate,
the mask and the substrate stage are configured to operate in synchronization in a plane direction that is substantially perpendicular to a direction of irradiation with the laser beam to thereby maintain a relatively corresponding positional relationship therebetween, and
the processing apparatus is configured to, during processing operation on the substrate, cause the mask and the substrate stage to operate in synchronization and subject the mask and the substrate stage to sweep irradiation with an irradiation position of the laser beam being fixed, to perform a surface protrusions-and-recesses forming process on the area to be processed of the substrate.

Furthermore, the processing method of the first aspect of the present invention is a processing method for forming minute protrusions and recesses on a surface of a substrate by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate, and,
during processing operation on the substrate, the mask and the substrate stage are subjected to sweep irradiation while superimposing a portion of one substrate irradiation area on a portion of another substrate irradiation area so as to perform a surface protrusions-and-recesses forming process of the area to be processed of the substrate.

Furthermore, the processing method of the second aspect of the present invention is a processing method for forming minute protrusions and recesses on a surface of a substrate by ablation processing using irradiation energy of a laser beam, the method including:
allowing the laser beam shaped into a rectangular shape to pass through a mask to thereby irradiate the substrate with the laser beam so as to make a substrate irradiation area smaller than an area to be processed of the substrate; and
performing, during processing operation on the substrate, a surface protrusions-and-recesses forming process on the area to be processed of the substrate while superimposing a portion of one substrate irradiation area on a portion of another substrate irradiation area.

Furthermore, the processing method of the third aspect of the present invention is a processing method for forming minute protrusions and recesses on a surface of a substrate by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate,
the mask and the substrate stage are caused to operate in synchronization in a plane direction that is substantially perpendicular to a direction of irradiation with the laser beam to thereby maintain a relatively corresponding positional relationship therebetween, and
during processing operation on the substrate, with an irradiation position of the laser beam being fixed, the mask and the substrate stage are caused to operate in synchronization and subjected to sweep irradiation to perform a surface protrusions-and-recesses forming process on the area to be processed of the substrate.

Furthermore, the manufacturing method of a substrate of the first aspect of the present invention is a manufacturing method of a substrate having a surface on which minute protrusions and recesses are formed by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate and,
during processing operation on the substrate, the mask and the substrate stage are subjected to sweep irradiation while superimposing a portion of one substrate irradiation area on a portion of another substrate irradiation area so as to perform a surface protrusions-and-recesses forming process on the area to be processed of the substrate.

Furthermore, the manufacturing method of a substrate of the second aspect of the present invention is a manufacturing method of a substrate having a surface on which minute protrusions and recesses are formed by ablation processing using irradiation energy of a laser beam, the method including:
a processing method for forming minute protrusions and recesses on a surface of a substrate by ablation processing using irradiation energy of a laser beam,
in which the laser beam shaped into a rectangular shape is allowed to pass through a mask to thereby irradiate the substrate with the laser beam so as to make a substrate irradiation area smaller than an area to be processed of the substrate and,
during processing operation on the substrate, a surface protrusions-and-recesses forming process on the area to be processed of the substrate is performed while superimposing a portion of one substrate irradiation area on a portion of another substrate irradiation area.

Furthermore, the manufacturing method of a substrate of the third aspect of the present invention is a manufacturing method of a substrate having a surface on which minute protrusions and recesses are formed by ablation processing using irradiation energy of a laser beam, the method including:
providing a processing apparatus including a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
in which the substrate irradiation area is made smaller than the area to be processed of the substrate,
the mask and the substrate stage are caused to operate in synchronization in a plane direction that is substantially perpendicular to a direction of irradiation with the laser beam to thereby maintain a relatively corresponding positional relationship therebetween, and,
during processing operation on the substrate, the mask and the substrate stage are caused to operate in synchronization with an irradiation position of the laser beam being fixed and subjected to sweep irradiation to perform a surface protrusions-and-recesses forming process on the area to be processed of the substrate.

Hereinafter, the present invention will be described in detail. However, the present invention is not limited thereto.

### [Processing Apparatus]

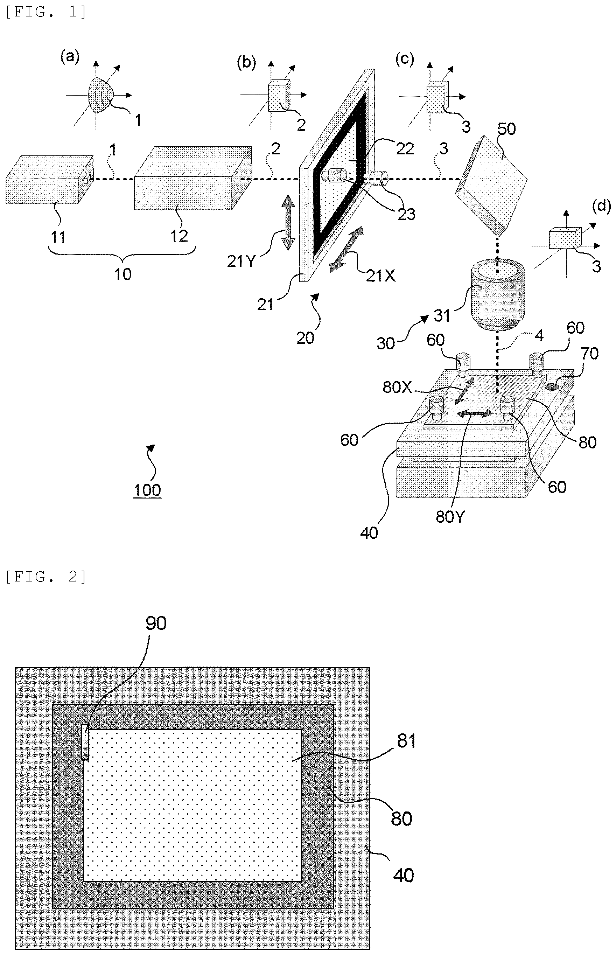

FIG. 1 is a schematic illustration showing an example of a processing apparatus of the present invention. A processing apparatus 100 shown in FIG. 1 is a processing apparatus that forms minute protrusions and recesses on a surface of a substrate 80 by ablation processing using irradiation energy of a laser beam 4.

The processing apparatus 100 shown in FIG. 1 includes a first optical function unit 10, a second optical function unit 20, and a substrate stage 40 that holds the substrate 80.

The first optical function unit 10 is provided with a laser light source (laser oscillator) 11 that performs irradiation (emission) of a laser beam 1 in pulse and a shaping optical system 12 that is irradiated with the laser beam 1 from the laser light source 11. The shaping optical system 12 shapes the irradiation shape of the laser beam 1 shown in, for example, FIG. 1(a) into the rectangular irradiation shape shown in, for example, FIG. 1(b). A laser beam 2 having the rectangular irradiation shape can exhibit uniform irradiation energy density, and has a beam profile that exhibits, for example, a top-hat shape.

The second optical function unit 20 is provided with a mask 21. The mask 21 contains an effective area 22 having a pattern corresponding to an area to be processed of the substrate 80.

The mask 21 includes a mask irradiation area to be irradiated with the laser beam 2 that has passed through the first optical function unit 10. The mask irradiation area is a part of the effective area 22 of the mask 21.

A laser beam 3 that has passed through the second optical function unit 20 and has the irradiation shape shown in, for example, FIG. 1(c) is changed in its advancing direction as shown in FIG. 1(d) by an optional reflecting mirror 50 and enters the optional third optical function unit 30 (described later). The processing apparatus 100 shown in FIG. 1 is configured to cause a laser beam 4 released from the third optical function unit 30 to irradiate a part of the substrate 80 held on the substrate stage 40.

The substrate 80 includes a substrate irradiation area onto which a pattern is projected by the laser beam that has passed through the mask 21 (and the optional third optical function unit 30).

FIG. 2 shows an example of the relationship between a substrate irradiation area 90 to be irradiated with the laser beam 4 of the substrate 80 and an area to be processed 81 of the substrate 80. As shown in FIG. 2, the substrate irradiation area 90 is smaller than the area to be processed 81 of the substrate 80.

The substrate irradiation area 90 shown in FIG. 2 is an area irradiated with one shot of the pulsed laser beam 4. Furthermore, since the pattern is projected onto the substrate irradiation area 90 by the laser beam that has passed through the mask 21, the substrate irradiation area 90 corresponds to the mask irradiation area that is a part of the effective area 22 of the mask 21.

In the example of FIG. 1, the mask 21 has a configuration allowing scanning (move with sweeping; sweep) along sweep axes 21X and 21Y shown in FIG. 1. Furthermore, the substrate stage 40 has a configuration allowing scanning along sweep axes 80X and 80Y shown in FIG. 1.

In addition, the processing apparatus 100 of the present invention is configured to perform sweep irradiation of the mask 21 and the substrate stage 40 with the laser beam 4 to perform a surface protrusions-and-recesses forming process on the area to be processed 81 of the substrate 80.

Moreover, the processing apparatus 100 of the present invention is configured to perform, as described in detail hereinbelow, superimposed irradiation (according to first aspect) and/or synchronous sweep irradiation with an irradiation position of the laser beam being fixed (according to second aspect).

### [First Aspect]

The processing apparatus 100 of the first aspect is configured to perform, during processing operation on the substrate 80, sweep irradiation of the mask 20 and the substrate stage 80 while superimposing a portion of the substrate irradiation area 90 on another portion of the substrate irradiation area 90 to perform a surface protrusions-and-recesses forming process on the area to be processed 81 of the substrate 80. Hereinafter, to perform irradiation with the laser beam while superimposing a portion of the substrate irradiation area 90 on another portion of the substrate irradiation are 90 is referred to as superimposed irradiation.

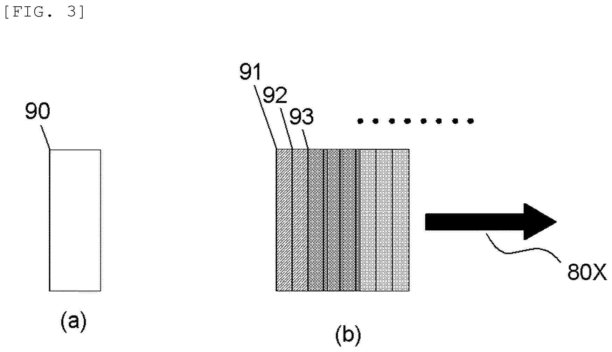

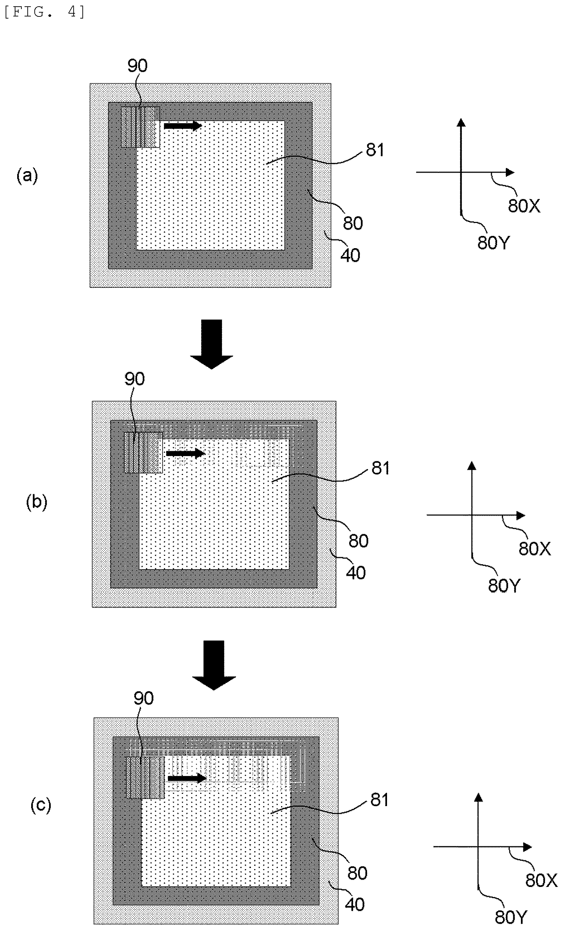

Next, an example of the superimposed irradiation will be described with reference to FIG. 3 and FIG. 4.

FIG. 3(a) shows the substrate irradiation area 90 on the substrate 80 to be irradiated with a pulsed one-shot of the laser beam. In the superimposed irradiation of this example, the mask 20 and the substrate stage 80 are made to move with sweeping and irradiated with the laser beam so that, as shown in FIG. 3(b), a portion of a substrate irradiation area 91 subjected to the first shot is superposed on a portion of a substrate irradiation area 92 subjected to the second shot in the direction of the arrow along the sweep axis 80X. Subsequently, irradiation with the laser beam is performed so that a substrate irradiation area 93 subjected to the third shot is partially superimposed on the substrate irradiation area 91 of the first shot and the substrate irradiation area 92 of the second shot. By repeating such superimposed irradiation of the fourth shot and later, the processing area is expanded along the sweep axis 80X.

FIG. 4(a) shows a process of performing ablation processing on the first row of the area to be processed 81 along the sweep axis 80X by the superimposed irradiation shown in FIG. 3(b). Next, as shown in FIG. 4(b), the superimposed irradiation is performed along the sweep axis 80X so as to superimpose on a portion of the areas that have been subjected to superimposed irradiation in FIG. 4(a) in the direction of the sweep axis 80Y (orthogonal to the sweep axis 80X) to perform ablation processing on the second row of the area to be processed 81 along the sweep axis 80X. Next, as shown in FIG. 4(c), the superimposed irradiation is performed along the sweep axis 80X so as to superimpose on a portion of the areas that have been subjected to superimposed irradiation in FIG. 4(a) and (b) in the direction of the sweep axis 80Y to perform ablation processing on the third row of the area to be processed 81 along the sweep axis 80X. By repeating such superimposed irradiation on the fourth and later rows of the area to be processed 81, the processing area is expanded across the area to be processed 81. As a result, superimposed irradiation can be performed at a regular interval in each of the two directions of the sweep axes 80X and 80Y.

The superimposed portions of the substrate irradiation area undergo multiple times of laser beam irradiation. As a result, the portions undergo deep ablation processing according to the pattern shape of the mask, and it is possible to achieve processing with the desired depth according to the pattern shape of the mask required for the area to be processed 81.

In such a processing apparatus 100 of the first aspect, the pulsed rectangular laser beam having uniform irradiation energy density is converted through the mask 21 into the laser beam 4 having processing shape and the substrate irradiation area 90 of the substrate 80 is irradiated with the laser beam 4. Therefore, multiple times of irradiation can be performed with a uniform processing depth of the substrate irradiation area 90 in the substrate 80 corresponding to the mask irradiation area that is a part of the effective area 22 of the mask 21, and a nearly uniform protrusions-and-recesses forming process can be accurately performed across the area to be processed 81 of the substrate 80. Therefore, according to this processing apparatus 100, it is possible to accurately perform a minute protrusions-and-recesses forming process across the area to be processed 81 of the substrate 80.

Furthermore, such a processing apparatus 100 does not require use of high laser energy, can be inexpensively configured without using an expensive laser light source and optical members, can suppress the deterioration of accuracy due to thermal drift of the laser beam, and can perform highly accurate processing.

In addition, the processing apparatus 100 can irradiate the substrate with the laser beam 4 in pulse, and thus can perform the above-described superimposed irradiation at high speed.

That is, according to the processing apparatus 100 of the first aspect of the present invention, it is possible to perform a deep VIA forming process and/or trench forming process at high speed.

Moreover, according to the processing apparatus 100 of the first aspect of the present invention, the superimposed irradiation is performed and thus the substrate irradiation area for one shot can be made small. As a result, high-density irradiation becomes possible.

### [Second Aspect]

In the processing apparatus 100 of the second aspect, the mask 21 and the substrate stage 40 are configured to operate in synchronization in a plane direction that is substantially perpendicular to a direction of irradiation of the laser beams 2 and 4 to thereby maintain a relatively corresponding relationship therebetween.

In the example of FIG. 1, the mask 21 and the substrate stage 40 are configured to synchronize the operation of the mask 21 along the sweep axis 21X with the operation of the substrate stage 80 along the sweep axis 80X, to synchronize the operation of the mask 21 along the sweep axis 21Y with the operation of substrate stage 80 along the sweep axis 80Y, and thereby to maintain a relatively corresponding relationship between the mask 21 and the substrate stage 40.

Furthermore, the processing apparatus 100 of the second aspect is configured to, during processing operation on the substrate 80, cause the mask 21 and the substrate stage 40 to operate in synchronization and subject the mask 21 and the substrate stage 40 to sweep irradiation with an irradiation position of the laser beam 4 being fixed to perform a surface protrusions-and-recesses forming process on the area to be processed 81 of the substrate 80. Such a sweep irradiation that can be performed by the processing apparatus 100 of the second aspect is hereinafter referred to as "synchronous sweep irradiation with the irradiation position of the laser beam being fixed".

With such a synchronous sweep irradiation, it is possible to perform processing with higher accuracy than in the case of scanning with (move) the laser beam. Furthermore, with such a processing apparatus 100, a large-area mask can also be used as the mask 21, and processing can also be performed at higher energy density by combined use of the large-area mask with the third optical function unit 30 described later.

Furthermore, in such a processing apparatus 100 of the second aspect, similarly to the processing apparatus 100 of the first aspect, the pulsed rectangular laser beam having uniform irradiation energy density is converted through the mask 21 into the laser beam 4 having a processing shape, and the substrate irradiation area 90 of the substrate 80 is irradiated with the laser beam 4. Therefore, also in the processing apparatus 100 of the second aspect, similarly to the first aspect, multiple times of irradiation can be performed with a uniformed processing depth of the substrate irradiation area 90 in the substrate 80 corresponding to the mask irradiation area that is a part of the effective area 22 of the mask 21, and a nearly uniform protrusions-and-recesses forming process can be accurately performed across the area to be processed 81 of the substrate 80. Therefore, also according to this processing apparatus 100, it is possible to accurately perform a minute protrusions-and-recesses forming process across the area to be processed 81 of the substrate 80.

Furthermore, such a processing apparatus 100 does not require use of high laser energy, can be inexpensively configured without using an expensive laser light source and optical members, can suppress the deterioration of accuracy due to thermal drift of the laser beam, and can perform highly accurate processing. Furthermore, since small components are available for optical components, inexpensive and highly accurate optical components can be used.

Note that it is preferable that the processing apparatus 100 of the first aspect is configured to perform, in addition to the superimposed irradiation described earlier, synchronous sweep irradiation with the irradiation position of the laser beam being fixed, similarly to the second aspect.

Hereinafter, optional matters for each component of the processing apparatus 100 of the present invention will be described.

### [First Optical Function Unit 10]

It is preferable that the laser beam 1 emitted from the laser source 11 is an excimer laser.

The excimer laser has shorter wavelength than a conventional solid-state laser such as a diode pumped solid-state (DPSS) laser and thus has higher resolving power. Therefore, use of the excimer laser enables a more precise protrusions-and-recesses forming process. Furthermore, for example, epoxy-based substrate materials have extremely large absorbability for the excimer laser, and the excimer laser has high processing capability to these materials.

It is preferable that the shaping optical system 12 is an optical system that includes a plurality of cylindrical lenses and shapes the laser beam 1 from the laser light source 11 into a laser beam that has the rectangular irradiation shape and uniform irradiation energy density, particularly a top-hat type laser beam.

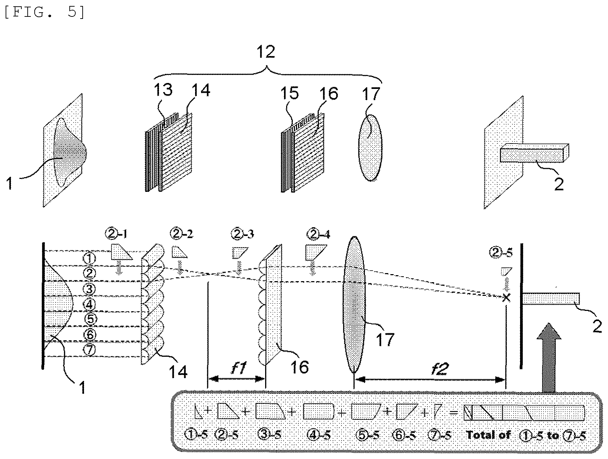

FIG. 5 shows a conceptual illustration of shaping the irradiation shape of a laser beam in a shaping optical system provided with a plurality of cylindrical lenses.

The shaping optical system 12 shown in FIG. 5 is provided with a plurality of cylindrical lenses constituted by an X1 cylindrical lens 13, a Y1 cylindrical lens 14, an X2 cylindrical lens 15, and a Y2 cylindrical lens 16, and a collecting lens 17. The X1 cylindrical lens 13 and the X2 cylindrical lens 15 are disposed with a spacing twice a focal distance f1 thereof as shown in a lower part of FIG. 5. The Y1 cylindrical lens 14 and the Y2 cylindrical lens 16 are also disposed with a spacing twice the focal distance thereof.

The laser beam 1 oscillated by the laser light source 11 shown in FIG. 1 has a non-uniform irradiation shape (beam profile) as shown in FIG. 5. Once the laser beam 1 having such an irradiation shape enters the shaping optical system 12, each component of the laser beam 1 is shaped according to positions in an X direction and a Y direction thereof. The lower part of FIG. 5 schematically shows how the component indicated by "2", for example, is shaped through the cylindrical lenses 14 and 16. Each component of the laser beam 1 is shaped by the cylindrical lenses 13 to 16 and collected at a position spaced from the collecting lens 17 by a focal distance f2. By collecting each component, the laser beam 2 having a top-hat beam shape as shown in FIG. 5 is formed and output from the shaping optical system 12 as an output beam.

By recombining the configuration of the cylindrical lenses in the X direction and the Y direction, it is possible to shape the beam shape into a square, a rectangle, or the like.

By shaping the irradiation shape of the laser beam 1 using a plurality of such cylindrical lenses 13 to 16, it is possible to shape the high-quality laser beam 2 that has a rectangular shape and extremely uniform energy density, particularly a top-hat type beam profile.

In particular, in the processing apparatus 100 of the first aspect, by performing the superimposed irradiation using such a rectangular beam profile, dead spots, which are areas not irradiated, are not generated and an averaged protrusions-and-recesses forming process can be performed within the tolerance range of the desired processing, enabling an extremely efficient protrusions-and-recesses forming process on the substrate 80.

### [Second Optical Function Unit 20]

It is preferable that the second optical function unit 20 further includes a mask stage that holds the mask 21 and makes the mask 21 move with sweeping.

By attaching a sweep shaft to the mask stage on which the mask 21 is held, sweep operation of the mask can be performed efficiently.

Furthermore, by adding a correction function (tilt axis, θ axis) to the mask stage, it is possible to easily make correction with respect to the surface shape of the substrate 80 to be processed, which enables correct processing.

The second optical function unit 20 may be configured to further shape the irradiation shape of the laser beam 2 through the mask 21, the laser beam 2 having passed through the first optical function unit 10.

The second optical function unit 20 can further shape the irradiation shape of the laser beam 2 shaped into a rectangular shape according to, for example, a pattern corresponding to the area to be processed 81 of the substrate 80.

It is preferable that the mask 21 is installed in a substantially perpendicular direction with respect to a horizontal plane on which the processing apparatus 100 is installed.

As described above, a large size is required for substrate processing, and consequently masks are becoming larger. Moreover, the mask size becomes even larger when a reduced projection optical system is used.

On the other hand, the degree of precision of a protrusions-and-recesses forming process on substrates is increasing, and any distortion in the image of the mask affects the accuracy of processing.

As in Patent Document 2, in the case of installing the mask in the same horizontal direction as the horizontal plane on which the apparatus is installed, installing the mask alone generates distortion due to the gravity thereof and deteriorate the processing accuracy.

In a case where a support is provided below the mask to suppress generation of deflection, although the support is required to be optically transparent, thickness of the support member is required to increase for larger mask, which causes a problem in cost and additionally deteriorates energy efficiency of the laser irradiation due to increased absorption of laser energy in the support material.

Furthermore, in the case where the mask is installed on the horizontal plane, the risk that dust is placed on the mask increases. In a case where production is carried out with the dust remains placed on the mask, quality defects are caused for a large amount of products.

Moreover, in a case where dust enters between the support material below the mask and the mask, not only products are defected and the mask is damaged due to the effect by the dust, but also optical non-uniformity is generated because the slight gap partially generated between the support material and the mask have a different refractive index. As a result, irradiation with a non-uniform laser beam will be performed.

Moreover, because the optical path length from the laser light source to the substrate is long, the height of the apparatus increases when the mask is horizontalized. By erecting the mask, the height of the apparatus can be reduced.

By virtue of installation of the mask 21 in a substantially perpendicular direction with respect to the horizontal plane on which the processing apparatus 100 is installed as in this preferred example, the mask 21 does not deflect and does not require a support for preventing deflection by an optically transparent material, which makes it possible to perform highly-accurate extremely-uniform processing with high use efficiency of the laser energy.

Note that, in the processing apparatus 100 of the present invention, the irradiation area of the laser beam 3 that has passed through the mask 21 can be reduced through the optional reduced optical system 31 described later to increase the energy density of the laser beam 4 to be irradiated to the substrate. Therefore, even if the large-area mask 21 is enlarged, the desired minute protrusions-and-recesses forming process can be performed by combined use of the reduced optical system 31 adapted to the enlarged mask 21.

The size of the mask 21 is not particularly limited. For example, it is possible to use the mask 21 having an outer shape of 700 mm × 800 mm and the effective area 22 of 600 mm × 600 mm.

### [Third Optical Function Unit 30]

As in the processing apparatus 100 shown in FIG. 1, it is preferable that the processing apparatus further includes, between the second optical function unit 20 and the substrate stage 40, the third optical function unit including the reduced projection optical system 31.

In recent years, processing of substrates is becoming more minute, and there are increasing requirements of a few micrometers as the minimum width of the processing. The process is also affected by minute dust, and in particular, minute dust adhering to the mask portion causes a large amount of processing defects. Therefore, by magnifying the mask 21 compared with the actual processing and subjecting the laser beam 3 that has passed through the mask 21 to reduced projection exposure in the reduced projection optical system 31 of the subsequent stage, effects on the minute dust can be minimized.

Furthermore, by magnifying the mask 21 compared with the actual processing pattern, the energy of the laser beam 2 irradiated to the mask 21 can be made smaller than the processing energy. When the reduction magnification of the reduced projection optical system 31 is N, the energy of the laser beam hitting the mask surface is 1/(N²) compared with the processing energy on the substrate 80 surface. As a result, thermal drift due to the energy of the laser beam 2 can be suppressed and therefore thermal expansion of the mask 21 can be suppressed, which enables highly accurate processing even after long-time processing operation.

Moreover, since deterioration of optical members (for example, the shaping optical system 12 and the mask 21) due to the heat of the laser beam can be suppressed, life-span of the optical members can be made longer.

In addition, in the above-described processing apparatus 100 configured to perform synchronous sweep irradiation with the irradiation position of the laser beam being fixed, it is possible to use a reduced projection lens having an extremely small aperture compared with the method in which the irradiation position of the laser beam is moved, such as the method of Patent Document 2. Therefore, in addition to being advantageous in terms of cost, less distortion of the lens and reduction of aberration by the lens can be achieved, and thereby the processing accuracy of the substrate can be significantly increased.

The reduced projection optical system 31 can be provided with a pair of reduced projection lenses. In a case where the reduced projection optical system 31 is an infinity optical system, the magnification by the reduced projection optical system 31 can be adjusted, for example, by the ratio of the focal distances of the reduced projection lenses and the distance between the reduced projection lenses.

It is preferable that the reduced projection lens has a high NA (numerical aperture). By using a reduced projection lens having a high NA, it is possible to form VIAs and trenches having a shape closer to the cylindrical shape.

It is preferable that the NA of the reduced projection lens is selected according to the energy density required for processing on the substrate 80. It is preferable that the NA of the reduced projection lens is 0.12 or more.

It is preferable that the third optical function unit 30 is further provided with a cooling means for cooling the reduced projection optical system 31.

By including the cooling means, it is possible to further suppress the effect of heat from the laser beam energy in the reduced projection optical system 30. In the reduced projection optical system 30, since the laser beam 3 that has passed through the mask 21 is subjected to reduced projection of 1/N, the energy of the laser beam passing through the lens portion of the objective tip is N² times larger than energy of the laser beam irradiated to the mask 21, and this portion is more likely to be affected by the heat. Therefore, by providing a cooling function to the reduced projection optical system 30 in order to suppress this thermal energy, thermal drift due to the energy of the laser beam can be suppressed, which enables highly accurate processing even after long-time processing operation.

In addition, in the above-described processing apparatus 100 configured to perform synchronous sweep irradiation with the irradiation position of the laser beam being fixed, it is possible to use a reduced projection lens having an extremely small aperture compared with the method of Patent Document 2. Regarding the cooling means for the reduced projection lens, the cooling means cannot be directly provided to the lens itself but cooling is provided to a jacket portion that holds the lens. Therefore, as the lens aperture becomes larger, the temperature can be managed in the area surrounding the lens, but near the central portion, which is the critical portion, cooling effect difficultly spreads, and the heat is difficultly managed. Therefore, even slight energy absorption into the lens due to the long-time laser beam irradiation easily causes distortion by heat. With the third optical function unit 30 having the cooling function, the lens aperture can be made small, and therefore such a problem can be suppressed.

Moreover, defects caused by the laser beam irradiation to the reduced projection optical system 31 can be suppressed and thereby the life-span thereof can be extended.

### [Sweep Mechanism]

It is preferable that the processing apparatus 100 is configured to make the mask 21 and the substrate stage 40 move with sweeping without rest in the sweep irradiation in at least one direction while irradiating the mask 21 and the substrate stage 40 with the laser beams 2 and 4, respectively, in pulse.

By performing the sweep irradiation without rest, the time of sweep can be significantly reduced compared with step-and-repeat operation in which traveling and rest are repeated. In particular, since positioning required in entering rest from the traveling state is eliminated, it is possible to prevent deterioration of positional accuracy due to the acceleration/deceleration.

Furthermore, since such an operation occurs frequently, the load on a traveling shaft and a motor becomes large when traveling and rest are repeated. By performing the sweep irradiation operation without rest, the load on the shaft can be reduced and heat generation at the traveling shaft portion can be suppressed, which enables further prevention of deterioration of the positional accuracy due to thermal drift and enables an extremely highly accurate substrate protrusions-and-recesses forming process.

### [Imaging Means and Alignment Mechanism]

It is preferable that the processing apparatus 100 of the present invention further includes an imaging means for reading a feature portion of the substrate 80, an imaging means for reading a feature portion of the mask 21, and an alignment mechanism that aligns relative positions of the substrate and the mask based on positional information on the feature portion of the substrate and the feature portion of the mask.

The processing apparatus 100 shown in FIG. 1 includes an alignment camera 23 for the mask as the imaging means for reading the feature portion of the mask 21, an alignment camera 60 for the substrate as the imaging means for reading the feature portion of the substrate 80, and the alignment mechanism not shown. The alignment camera 23 for the mask is configured to send positional information on the feature portion of the mask 21 to the alignment mechanism. The alignment camera 60 for the substrate is configured to send positional information on the feature portion of the substrate 80 to the alignment mechanism. The alignment mechanism is configured to align the relative positions of the substrate 80 and the mask 21 based on these pieces of positional information.

By aligning the position of the mask 21 with the position of the substrate 80 by the imaging means, it is possible to perform the protrusions-and-recesses forming process in which the mask pattern is to be projected onto the correct position of the substrate 80 surface.

In particular, the substrate is often processed over a plurality of layers, and if the processing position of each layer is not correctly aligned with the desired position, quality defects occur, for example, circuits of layers are not connected to each other, or even when the connection is established, conduction resistance is high. In order to suppress the quality defects, correctness of the processing position is required.

In this case, it is preferable that a means for correcting a processing shape of the substrate 80 with respect to the pattern of the mask 21 based on information of the alignment mechanism is further included.

The shape of the projected image of the pattern of the mask 21 is not always correctly similar shape with respect to the processing shape on the substrate 80, and the magnification is not always the same due to the effect of thermal expansion or the like. Furthermore, in some cases, due to small distortion or deformation of the substrate 80, the processing shape on the substrate 80 is required to be deformed with respect to the projected image of the mask 21.

Therefore, as described above, the position of the mask 21 and the position of the substrate 80 are acquired by the imaging means (the alignment camera 23 for the mask and the alignment camera 60 for the substrate), and, based on information therefrom, the projected image of the mask 21 is aligned with the shape on the substrate to be processed, thereby enabling a correct protrusions-and-recesses forming process on the substrate.

Specifically, for example, the projection position of the projected image of the mask 21 is acquired by a beam image detection camera 70 and corrected based on the information on this projection position to optimize the projection magnification by the third optical function unit 30, and the sweep speed during sweep irradiation is optimized based on the above-described information. As a result, the longitudinal magnification and the lateral magnification of the substrate 80 with respect to the image of the mask 21 can be changed arbitrarily within a certain degree of range, and the optimal substrate processing shape can be applied.

### [Processing Method]

The processing method of the first aspect of the present invention is a method of performing the superimposed irradiation described earlier using the processing apparatus 100 of the first aspect described above. Therefore, according to the processing method of the first aspect of the present invention, it is possible to accurately perform a minute protrusions-and-recesses forming process across the area to be processed of the substrate. In addition, irradiation at high energy density can be performed, and a deep VIA forming process and/or trench forming process can be performed at high speed.

The processing method of the present invention is not limited to the method using the processing apparatus 100 of the first aspect described above.

For example, the processing method of the second aspect of the present invention is a processing method for forming minute protrusions and recesses on a surface of a substrate by ablation processing using irradiation energy of a laser beam, the method including: allowing the laser beam shaped into a rectangular shape to pass through a mask to thereby irradiate the substrate with the laser beam so as to make a substrate irradiation area smaller than an area to be processed of the substrate; and performing, during processing operation on the substrate, a surface protrusions-and-recesses forming process on the area to be processed of the substrate while superimposing a portion of one substrate irradiation area on a portion of another substrate irradiation area.

With such a processing method, irradiation of the laser beam is performed so as to make the substrate irradiation area smaller than the area to be processed of the substrate, and the surface protrusions-and-recesses forming process on the area to be processed of the substrate is performed while superimposing a portion of one substrate irradiation area on a portion of another substrate irradiation area, in other words, the superimposed irradiation is performed. Therefore, it is possible to accurately perform the nearly uniform protrusions-and-recesses forming process across the area to be processed of the substrate. Therefore, with the processing apparatus of this aspect, it is possible to accurately perform a minute protrusions-and-recesses forming process across the area to be processed of the substrate.

Note that, with the processing method of the second aspect of the present invention, use of the excimer laser enables a more precise protrusions-and-recesses forming process.

Alternatively, the processing method of the third aspect of the present invention is a method of performing the above-described synchronous sweep irradiation with the irradiation position of the laser beam being fixed, using the processing apparatus 100 of the above-described second aspect. Therefore, according to the processing method of the third aspect of the present invention, the minute protrusions-and-recesses forming process can be accurately performed across the area to be processed of the substrate. Furthermore, according to the processing method of the third aspect, processing can be performed with higher accuracy than in the case of moving (scanning with) a laser beam. Furthermore, with such a processing method, a large-area mask can also be used as the mask 21, and processing can also be performed at higher energy density by combined use of the large-area mask with the third optical function unit 30 described earlier.

It is particularly preferable to perform, during the processing operation on the substrate, both the above-described superimposed irradiation and the above-described synchronous sweep irradiation with the irradiation position of the laser beam being fixed.

In the processing method of the first aspect or the third aspect of the present invention, it is preferable to use the processing apparatus 100 that satisfies one or more of the optional matters described earlier.

Furthermore, in the processing method of the first aspect or the third aspect of the present invention, it is preferable that, in the sweep irradiation in at least one direction, the mask 21 and the substrate stage 40 are moved with sweeping without rest while the mask 21 and the substrate stage 40 are irradiated with the laser beam 2 and 4, respectively, in pulse.

By performing such a sweep, due to the reason described earlier, the time of the sweep can be significantly reduced compared with the step-and-repeat operation in which traveling and rest are repeated.

Furthermore, in the processing method of the first aspect or the third aspect of the present invention, it is preferable to repeat the sweep irradiation multiple times for each area to be processed 81 of the substrate 80.

As described above, high-aspect processing is required, in which a precise protrusions-and-recesses forming process of the substrate is required but deep processing is desired at the same time.

However, the depth achieved by one sweep (1 pass) is limited, and especially in the above-described processing by the sweep without rest, irradiation cannot be performed multiple times on a processing portion for one time.

Therefore, by performing laser pulse irradiation while performing moving with sweeping (sweep) and repeating the irradiation multiple times for each area to be processed 81 of the substrate 80, processing to the desired depth can be performed and high-speed processing can be performed.

Note that, between sweep operations (first sweep, second sweep, ...), as described with reference to FIGS. 3 and 4, for example, the irradiation is performed with displacing the substrate irradiation area 90 each time to thereby average the processing depth and enable processing of a uniform depth.

It is preferable that the processing method of the first aspect or the third aspect further includes reading a feature portion of the substrate 80 and a feature portion of the mask 21, and aligning, using the alignment mechanism, relative positions of the substrate 80 and the mask 21 based on positional information on the feature portion of the substrate 80 and the feature portion of the mask 21.

The feature portion of the substrate 80 can be read, for example, by the alignment camera 60 for the substrate. The feature portion of the mask 21 can be read using, for example, the alignment camera 23 for the mask.

By aligning the position of the mask 21 with the position of the substrate 80 by the alignment mechanism based on the information obtained by the above-described alignment cameras 23 and 60, it becomes possible to perform a protrusions-and-recesses forming process in which the mask pattern is projected onto the correct position of the substrate 80 surface.

In this case, it is preferable that the processing method further includes correcting a processing shape on the substrate 80 with respect to the pattern of the mask 21 based on information of the alignment mechanism.

Such a processing method enables a more correct protrusions-and-recesses forming process on the substrate. Such a correction can be made, for example, by combining the third optical function unit 30, the beam image detection camera 70, the sweep mechanism for the mask 21, the sweep mechanism for the substrate stage 80, and the like.

### [Manufacturing Method of Substrate]

In the manufacturing method of a substrate of the present invention, the substrate is processed by the processing method of the present invention.

According to such a manufacturing method of the substrate, multiple times of irradiation can be performed with a uniformed processing depth of the substrate irradiation area in the substrate corresponding to the mask irradiation area that is a part of the effective area of the mask, and therefore a nearly uniform protrusions-and-recesses forming process can be accurately performed across the area to be processed of the substrate. Therefore, according to the manufacturing method of a substrate of this aspect, the substrate in which minute protrusions and recesses are accurately formed across the area to be processed of the substrate can be manufactured.

Furthermore, such a manufacturing method of a substrate does not require use of high laser energy, can be inexpensively performed without using an expensive laser light source and optical members, can suppress the deterioration of accuracy due to thermal drift of the laser beam, and enables manufacturing of the highly-accurately processed substrate.

In particular, with the manufacturing method of a substrate in which the processing method of the first aspect described above is performed, since the above-described superimposed irradiation is performed during the processing operation on the substrate, a deep VIA forming process and/or trench forming process can be performed at high speed. Furthermore, since the substrate irradiation area for one shot can be made small, high-density irradiation is enabled.

Furthermore, with the manufacturing method of a substrate in which the processing method of the third aspect described above is performed, since the above-described synchronous sweep irradiation with the irradiation position of the laser beam being fixed is performed during the processing operation on the substrate, processing can be performed with higher accuracy than in the case of scanning with (moving) the laser beam. Furthermore, with such a processing method, a large-area mask can also be used, and therefore processing can also be performed at higher energy density.

The manufacturing method of a substrate of the present invention can be applied particularly advantageously to manufacturing of a semiconductor package.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A processing apparatus that forms minute protrusions and recesses on a surface of a substrate by ablation processing using irradiation energy of a laser beam, the apparatus comprising:
a first optical function unit including a laser light source that performs irradiation with the laser beam in pulse and a shaping optical system that shapes an irradiation shape of the laser beam from the laser light source into a rectangular shape;
a second optical function unit including a mask containing an effective area having a pattern corresponding to an area to be processed of the substrate; and
a substrate stage that holds the substrate,
wherein the mask includes a mask irradiation area to be irradiated with the laser beam that has passed through the first optical function unit, the mask irradiation area being a part of the effective area of the mask,
the substrate includes a substrate irradiation area onto which the pattern is to be projected by the laser beam that has passed through the mask,
the substrate irradiation area is smaller than the area to be processed of the substrate, and
the processing apparatus is configured to perform a surface protrusions-and-recesses forming process on the area to be processed of the substrate by performing, during processing operation on the substrate, sweep irradiation of the mask and the substrate stage while superimposing a portion of one substrate irradiation area on a portion of another substrate irradiation area.

2. A processing apparatus that forms minute protrusions and recesses on a surface of a substrate by ablation processing using irradiation energy of a laser beam, the apparatus comprising:
a first optical function unit including a laser light source that performs irradiation with the laser beam in pulse and a shaping optical system that shapes an irradiation shape of the laser beam from the laser light source into a rectangular shape;
a second optical function unit including a mask containing an effective area having a pattern corresponding to an area to be processed of the substrate; and
a substrate stage that holds the substrate,
wherein the mask includes a mask irradiation area to be irradiated with the laser beam that has passed through the first optical function unit, the mask irradiation area being a part of the effective area of the mask,
the substrate includes a substrate irradiation area onto which the pattern is to be projected by the laser beam that has passed through the mask,
the substrate irradiation area is smaller than the area to be processed of the substrate,
the mask and the substrate stage are configured to operate in synchronization in a plane direction that is substantially perpendicular to a direction of irradiation with the laser beam to thereby maintain a relatively corresponding positional relationship therebetween, and
the processing apparatus is configured to, during processing operation on the substrate, cause the mask and the substrate stage to operate in synchronization and subject the mask and the substrate stage to sweep irradiation with an irradiation position of the laser beam being fixed to perform a surface protrusions-and-recesses forming process on the area to be processed of the substrate.

3. The processing apparatus according to claim 1,
wherein the mask and the substrate stage are configured to operate in synchronization in a plane direction that is substantially perpendicular to a direction of irradiation with the laser beam to thereby maintain a relatively corresponding positional relationship therebetween, and
the processing apparatus is configured to perform a surface protrusions-and-recesses forming process on the area to be processed of the substrate by, during processing operation on the substrate, causing the mask and the substrate stage to operate in synchronization with an irradiation position of the laser beam being fixed and subject the mask and the substrate stage to sweep irradiation while superimposing a portion of one substrate irradiation area on a portion of another substrate irradiation area.

4. The processing apparatus according to any one of claims 1 to 3,
wherein the laser beam is an excimer laser.

5. The processing apparatus according to any one of claims 1 to 4, further comprising a mask stage that holds the mask and makes the mask move with sweeping.

6. The processing apparatus according to any one of claims 1 to 5, further comprising, between the second optical function unit and the substrate stage, a third optical function unit including a reduced projection optical system.

7. The processing apparatus according to claim 6,
wherein the third optical function unit further includes a cooling means for cooling the reduced projection optical system.

8. The processing apparatus according to any one of claims 1 to 7,
wherein the shaping optical system is an optical system that includes a plurality of cylindrical lenses and shapes the laser beam from the laser light source into a laser beam having the rectangular irradiation shape and uniform irradiation energy density.

9. The processing apparatus according to any one of claims 1 to 7,
wherein the shaping optical system is an optical system that includes a plurality of cylindrical lenses and shapes the laser beam from the laser light source into a laser beam that has the rectangular and top-hat type irradiation shape.

10. The processing apparatus according to any one of claims 1 to 9,
wherein the second optical function unit further shapes the irradiation shape of the laser beam through the mask, the laser beam having passed through the first optical function unit.

11. The processing apparatus according to any one of claims 1 to 10,
wherein the apparatus is configured to make the mask and the substrate stage move with sweeping without rest in the sweep irradiation in at least one direction while irradiating the mask and the substrate stage with the laser beam in pulse.

12. The processing apparatus according to any one of claims 1 to 11, further comprising:
an imaging means for reading a feature portion of the substrate;
an imaging means for reading a feature portion of the mask; and
an alignment mechanism that aligns relative positions of the substrate and the mask based on positional information on the feature portion of the substrate and the feature portion of the mask.

13. The processing apparatus according to claim 12, further comprising a means for correcting a processing shape of the substrate with respect to the pattern of the mask based on information of the alignment mechanism.

14. The processing apparatus according to any one of claims 1 to 13,
wherein the mask is installed in a substantially perpendicular direction with respect to a horizontal plane on which the processing apparatus is installed.

15. A processing method for forming minute protrusions and recesses on a surface of a substrate by ablation processing using irradiation energy of a laser beam, the method comprising:
providing a processing apparatus comprising a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
wherein the substrate irradiation area is made smaller than the area to be processed of the substrate, and,
during processing operation on the substrate, the mask and the substrate stage are subjected to sweep irradiation while superimposing a portion of one substrate irradiation area on a portion of another substrate irradiation area so as to perform a surface protrusions-and-recesses forming process on the area to be processed of the substrate.

16. A processing method for forming minute protrusions and recesses on a surface of a substrate by ablation processing using irradiation energy of a laser beam, the method comprising:
allowing the laser beam shaped into a rectangular shape to pass through a mask to thereby irradiate the substrate with the laser beam so as to make a substrate irradiation area smaller than an area to be processed of the substrate; and
performing, during processing operation on the substrate, a surface protrusions-and-recesses forming process on the area to be processed of the substrate while superimposing a portion of one substrate irradiation area on a portion of another substrate irradiation area.

17. A processing method for forming minute protrusions and recesses on a surface of a substrate by ablation processing using irradiation energy of a laser beam, the method comprising:
providing a processing apparatus comprising a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
wherein the substrate irradiation area is made smaller than the area to be processed of the substrate,
the mask and the substrate stage are caused to operate in synchronization in a plane direction that is substantially perpendicular to a direction of irradiation with the laser beam to thereby maintain a relatively corresponding positional relationship therebetween, and,
during processing operation on the substrate, with an irradiation position of the laser beam being fixed, the mask and the substrate stage are caused to operate in synchronization and subjected to sweep irradiation to perform a surface protrusions-and-recesses forming process on the area to be processed of the substrate.

18. The processing method according to claim 15,
wherein the mask and the substrate stage are caused to operate in synchronization in a plane direction that is substantially perpendicular to a direction of irradiation with the laser beam to thereby maintain a relatively corresponding positional relationship therebetween, and
during processing operation on the substrate, with an irradiation position of the laser beam being fixed, the mask and the substrate stage are caused to operate in synchronization and subjected to sweep irradiation while superimposing a portion of one substrate irradiation area on a portion of another substrate irradiation area so as to perform a surface protrusions-and-recesses forming process on the area to be processed of the substrate.

19. The processing method according to claim 15, 17, or 18,
wherein an excimer laser is used as the laser beam.

20. The processing method according to claim 16,
wherein an excimer laser is used as the laser beam.

21. The processing method according to any one of claims 15 and 17 to 19,
wherein a mask stage that holds the mask and makes the mask move with sweeping is further used.

22. The processing method according to any one of claims 15, 17 to 19, and 21,
wherein the processing apparatus further includes, between the second optical function unit and the substrate stage, a third optical function unit with a reduced projection optical system provided.

23. The processing method according to claim 22,
wherein the third optical function unit further includes a cooling means for cooling the reduced projection optical system.

24. The processing method according to any one of claims 15, 17 to 19, and 21 to 23,
wherein an optical system including a plurality of cylindrical lenses is used as the shaping optical system to shape the laser beam from the laser source into a uniform laser beam having the rectangular irradiation shape.

25. The processing method according to any one of claims 15, 17 to 19, and 21 to 24,
wherein, in the second optical function unit, the irradiation shape of the laser beam that has passed through the first optical function unit is further shaped through the mask.

26. The processing method according to any one of claims 15, 17 to 19, and 21 to 25,
wherein, in the sweep irradiation in at least one direction, the mask and the substrate stage are made to move with sweeping without rest while being irradiated with the laser beam in pulse.

27. The processing method according to any one of claims 15, 17 to 19, and 21 to 26,
wherein the sweep irradiation is repeatedly performed multiple times for each area to be processed of the substrate.

28. The processing method according to any one of claims 15, 17 to 19, and 21 to 27, further comprising:
reading a feature portion of the substrate and a feature portion of the mask; and
aligning, by using an alignment mechanism, relative positions of the substrate and the mask based on positional information on the feature portion of the substrate and the feature portion of the mask.

29. The processing method according to claim 28, further comprising correcting a processing shape of the substrate with respect to the pattern of the mask based on the information of the alignment mechanism.

30. The processing method according to any one of claims 15, 17 to 19, and 21 to 29,
wherein the processing apparatus in which the mask is installed in a perpendicular direction with respect to a horizontal plane on which the processing apparatus is to be installed is used.

31. A manufacturing method of a substrate having a surface on which minute protrusions and recesses are formed by ablation processing using irradiation energy of a laser beam, the method comprising:
providing a processing apparatus comprising a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
wherein the substrate irradiation area is made smaller than the area to be processed of the substrate and,
during processing operation on the substrate, the mask and the substrate stage are subjected to sweep irradiation while superimposing a portion of one substrate irradiation area on a portion of another substrate irradiation area so as to perform a surface protrusions-and-recesses forming process on the area to be processed of the substrate.

32. A manufacturing method of a substrate having a surface on which minute protrusions and recesses are formed by ablation processing using irradiation energy of a laser beam, the method comprising:
a processing method for forming minute protrusions and recesses on a surface of a substrate by ablation processing using irradiation energy of a laser beam,
wherein the laser beam shaped into a rectangular shape is allowed to pass through a mask to thereby irradiate the substrate with the laser beam so as to make a substrate irradiation area smaller than an area to be processed of the substrate and,
during processing operation on the substrate, a surface protrusions-and-recesses forming process on the area to be processed of the substrate is performed while superimposing a portion of one substrate irradiation area on a portion of another substrate irradiation area.

33. A manufacturing method of a substrate having a surface on which minute protrusions and recesses are formed by ablation processing using irradiation energy of a laser beam, the method comprising:
providing a processing apparatus comprising a first optical function unit including a laser light source and a shaping optical system, a second optical function unit including a mask containing an effective area having a pattern corresponding to an area to be processed of the substrate, and a substrate stage that holds the substrate;
irradiating, in the first optical function unit, the shaping optical system with the laser beam in pulse from the laser light source to shape an irradiation shape of the laser beam into a rectangular shape;
irradiating, in the second optical function unit, a mask irradiation area with the laser beam that has passed through the first optical function unit, the mask irradiation area being a part of the effective area of the mask; and
irradiating a substrate irradiation area of the substrate with the laser beam that has passed through the mask to project the pattern onto the substrate irradiation area,
wherein the substrate irradiation area is made smaller than the area to be processed of the substrate,
the mask and the substrate stage are caused to operate in synchronization in a plane direction that is substantially perpendicular to a direction of irradiation with the laser beam to thereby maintain a relatively corresponding positional relationship therebetween, and,
during processing operation on the substrate, the mask and the substrate stage are caused to operate in synchronization with an irradiation position of the laser beam being fixed and subjected to sweep irradiation to perform a surface protrusions-and-recesses forming process on the area to be processed of the substrate.

34. The manufacturing method of a substrate according to any one of claims 31 to 33,
wherein the substrate is a substrate for a semiconductor package.
